(19) Europäisches Patentamt

European Patent Office

Office européen des brevets

(11) **EP 1 452 326 A2**

(12) **EUROPEAN PATENT APPLICATION**

(43) Date of publication:
**01.09.2004 Bulletin 2004/36**

(51) Int Cl.⁷: **B41J 11/00**, B41M 3/00, H05K 3/12

(21) Application number: **04250997.6**

(22) Date of filing: **24.02.2004**

| | |
|---|---|
| (84) Designated Contracting States:<br>**AT BE BG CH CY CZ DE DK EE ES FI FR GB GR HU IE IT LI LU MC NL PT RO SE SI SK TR**<br>Designated Extension States:<br>**AL LT LV MK**<br><br>(30) Priority: **26.02.2003 JP 2003049369**<br>        **02.09.2003 JP 2003310678**<br>        **14.01.2004 JP 2004007153**<br><br>(71) Applicant: **Seiko Epson Corporation**<br>**Shinjuku-ku, Tokyo 163-0811 (JP)** | (72) Inventors:<br>• **Miura, Hirotsuna, Seiko Epson Corporation**<br>  **Nagano-ken 392-8502 (JP)**<br>• **Furusawa, Masahiro, Seiko Epson Corporation**<br>  **Nagano-ken 392-8502 (JP)**<br>• **Amako, Jun, Seiko Epson Corporation**<br>  **Nagano-ken 392-8502 (JP)**<br><br>(74) Representative: **Sturt, Clifford Mark et al**<br>**Miller Sturt Kenyon**<br>**9 John Street**<br>**London WC1N 2ES (GB)** |

(54) **Method and apparatus for fixing a functional material onto a surface**

(57)    It is an object of the present invention to provide a method for fixing a functional material with good accuracy in a prescribed position on a fixing surface. In order to attain this object, the present invention provides a method for fixing a functional material, comprising a droplet ejection step of ejecting a droplet of a functional material dispersed in a solvent onto a fixing surface, and a drying step of locally heating the droplet ejected on the fixing surface and gasifying part of the droplet by irradiating the droplet with a laser beam. According to this method, the droplet can be dried rapidly, heating of the entire substrate is suppressed, and loss of alignment or breakage of wiring or the like caused by the expansion of substrate can be avoided.

## Fig.1

## Description

BACKGROUND OF THE INVENTION

Field of the Invention

The present invention relates to a fixing technology for functional materials, more specifically to an improved technology for fixing a functional material in the desired position with good accuracy.

Description of the Related Art

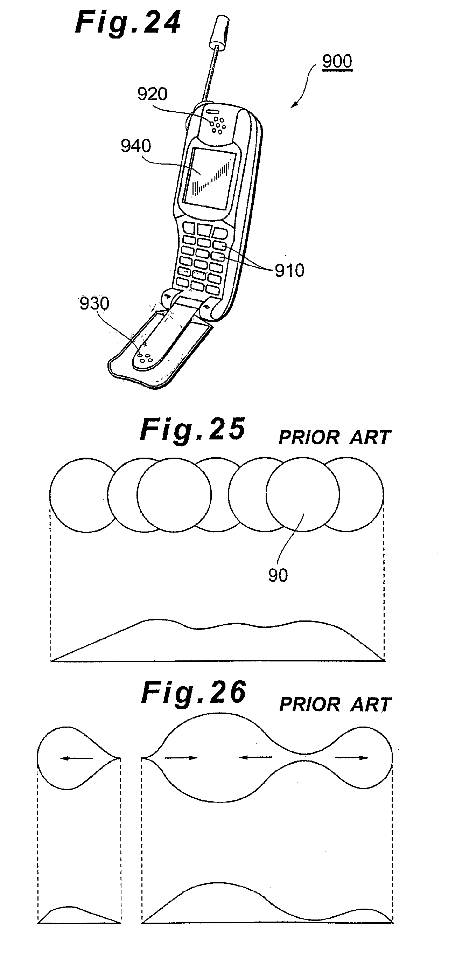

A droplet ejection method is known as a method for patterning wirings or the like. With this method, as disclosed in Japanese Patent Application Laid-open No. 2002-261048, first, droplets containing fine electrically conductive particles such as fine silver particles are ejected onto a fixing surface such as a wiring substrate and applied thereto according to the wiring shape. Then, the droplets applied to the substrate are naturally dried and then heated and fired together with the substrate to form a wiring. However, because the weight content ratio of the fine silver particles contained in the solution is as low as about 60%, if the solution is dried, the thickness thereof becomes significantly less than that prior to drying. For this reason, a wiring with a sufficient thickness has been conventionally formed, as shown in FIG. 25, by applying the droplets so that the adjacent droplets 90 partially overlap each other.

However, when the droplets overlap each other as shown in the figure, a surface tension acts upon a plurality of droplets applied to the substrate and they are deformed trying to assume a spherical shape. As a result, a local movement of droplets occurs and a pool 91 is formed as shown in FIG. 26. If such local coagulation occurs, the wiring thickness becomes non uniform or the wiring breakage can occur. Such problems can be encountered even when the adjacent droplets are ejected to overlap one another to a very small degree.

In order to resolve those problems drying the droplets coated on the substrate with a nitrogen blow or IR lamp can be considered, but such a drying process is time consuming and the throughput is decreased. Moreover, the nitrogen blow or IR lamp cause the expansion of the substrate itself, thereby causing loss of alignment or creating the risk of breaking the wiring formed on the substrate. At the same time, because the atmosphere is also heated, the droplet travel trajectory can be bent in the unintentional direction and the droplet ejection control can become difficult.

SUMMARY OF THE INVENTION

It is an object of the present invention to provide an improved technology for fixing a functional material with good accuracy in the prescribed position on a fixing surface.

In order to attain this object, the present invention provides a method for fixing a functional material, comprising the steps of: ejecting the droplets of a functional material dispersed in a solvent onto a fixing surface; irradiating the droplets ejected on the fixing surface with a laser beam ; and locally heating the droplets and gasifying part of the droplets. With such a method, the droplets can be dried rapidly, heating of the entire substrate is suppressed, and loss of alignment or breakage of wiring caused by the expansion of substrate can be avoided. The term "functional material" as used herein generally describes a material for a desired application and realizing a desired function.

The method for fixing a functional material in accordance with the present invention comprises the steps of: discretely ejecting a plurality of droplets of a functional material dispersed in a solvent onto a fixing surface so that the droplets are not in contact with each other; irradiating the droplets ejected on the fixing surface with a laser beam; and locally heating the droplets and gasifying part of the droplets. With such a method local movement of droplets on the substrate can be suppressed and highly accurate droplet ejection control can be carried out with good stability.

In the preferred embodiment of the present invention, the aforesaid method further comprises the steps of: newly ejecting second droplets onto the fixing surface so that they be brought into contact with the first droplets in which part of the solvent was gasified; irradiating the second droplets with a laser beam; and locally heating the second droplets and gasifying part of the second droplets. Newly ejecting the second droplets so that they be brought into contact with the dried first droplets makes it possible to suppress local movement of the droplets on the substrate and to avoid breakage of wiring.

The method for fixing a functional material in accordance with the present invention is a method for fixing a functional material by using a first ink-jet head and a second ink-jet head positioned downstream of the first ink-jet head, this method comprising the steps of: discretely ejecting a plurality of droplets of a functional material dispersed in a solvent onto a fixing surface so that the plurality of the first droplets are not in contact with each other by using the first ink-jet head; irradiating the droplets ejected on the fixing surface with a laser beam; locally heating at least two of the first droplets and gasifying part of the droplets, ejecting a second droplet so that it comes into contact with the two droplets that were partially dried, by using the second ink-jet head; irradiating the second droplet with a laser beam; and locally heating the second droplet and gasifying part of the second droplet. Such a method allows the throughput to be increased.

In the preferred embodiment of the present invention, the aforesaid method further comprises the steps of: irradiating the functional material dried and fixed to the fixing surface with a laser beam; and locally heating and sintering the functional material. The functional material can be sintered by adjusting the intensity of the laser beam.

A method for fixing a functional material in accordance with the present invention comprises the steps of: irradiating a functional material dried and fixed to a fixing surface with a laser beam, and locally heating and sintering the functional material. The functional material can be sintered by adjusting the intensity of the laser beam.

In the preferred embodiment of the present invention, the functional material contained in the solvent is dispersed in the solvent in a state in which the functional material is coated with a film. Coating the functional material with a film makes it possible to disperse the functional material with good stability in the solvent.

In the preferred embodiment of the present invention, the droplets comprise a photothermal conversion material having an absorption band in a wavelength region of the laser beam, and part of the solvent is gasified mainly by a photothermal conversion effect of the photothermal conversion material. Using the photothermal conversion material makes it possible to increase greatly the light utilization efficiency and heat the droplets effectively even at a laser wavelength of about 1 μm or less.

In the preferred embodiment of the present invention, the wavelength region of the laser beam is an IR region, and part of the solvent is gasified mainly by intrinsic absorption of the droplets. Using the intrinsic absorption of the droplets caused by local laser heating makes it possible to dry the droplets at a high rate.

In the preferred embodiment of the present invention, the droplets are irradiated with a laser beam from the side where the droplets are ejected onto the fixing surface. In such a case, not only a substrate transparent with respect to the laser wavelength region, but also a substrate which is not transparent with respect to the laser wavelength region can be employed as the substrate for applying the droplets. Therefore, the range for material selection is expanded.

In the preferred embodiment of the present invention, the fixing surface is the surface of a substrate transparent with respect to a wavelength region of the laser beam, and the droplets are irradiated with the laser beam from the rear surface side of the transparent substrate. Using a transparent substrate as the substrate for applying the droplets makes it possible to conduct laser irradiation from the rear side of the fixing surface and appropriate drying and fixing can be conducted even when the solvent contained in the droplets is a highly volatile solvent.

In the preferred embodiment of the present invention, the method comprises the steps of: ejecting substantially simultaneously a plurality of droplets; and irradiating substantially simultaneously a plurality of droplets ejected onto the fixing surface with a plurality of laser beams. Because a plurality of droplet ejection and drying operations are carried out substantially simultaneously, the throughput can be increased.

In the preferred embodiment of the present invention, the method comprises the steps of: splitting a single laser beam into a plurality of laser beams with a diffraction optical element; and irradiating the plurality of droplets with the split beams. Using the diffraction optical element makes it possible to split a single laser beam into a plurality of diffraction beam arrays.

In the preferred embodiment of the present invention, the method comprises a step of irradiating the plurality of droplets with a plurality of laser beams by using a semiconductor laser array in which a plurality of semiconductor lasers are arranged into an array. Using the semiconductor lasers makes it possible to reduce the size of the apparatus.

In the preferred embodiment of the present invention, the method comprises the steps of: rotating the diffraction optical element or the semiconductor laser array around the direction normal to the fixing surface; and adjusting a beam pitch of the laser beam so as to match the arrangement pitch of the droplets. Such a method makes it possible to pattern the function material according to any pattern.

In the preferred embodiment of the present invention, the method comprises a step of irradiating together a plurality of droplets with a laser beam shaped such that the plurality of droplets can be laser irradiated at the same time. With such a method alignment of laser irradiation is facilitated and a plurality of droplets can be dried and fixed simultaneously. As a result, the throughput is increased.

In the preferred embodiment of the present invention, the intensity distribution of the laser beam has a ring-like, elliptic, or rod-like shape. If the intensity distribution of the laser beam has a ring-like shape, the outer edge of fine functional particles can be dried reliably. Therefore, diffusion of fine functional particles can be suppressed. Furthermore, if the intensity distribution of the laser beam has an elliptic or rod-like shape, the heating interval of the droplets can be necessarily and sufficiently extended. Therefore, stable drying and fixing can be conducted.

In the preferred embodiment of the present invention, the laser beam has a beam profile in which the intensity on the outer edge of the irradiated region is higher than that inside thereof. If the droplets are irradiated with the laser beam having such a beam profile, the outer edge of droplets can be dried reliably. Therefore, displacement of the droplets from the impact position during drying can be suppressed.

In the preferred embodiment of the present invention, drying and sintering of the droplets are implemented continuously by scanning the droplets with a laser beam having an intensity gradient such that the intensity increases gradually from the front edge to the rear edge of the irradiated region. Conducting the drying step and sintering step continuously with the same laser beam increases the throughput.

The apparatus for fixing a functional material in accordance with the present invention comprises droplet ejection means for ejecting the droplets of a functional material dispersed in a solvent onto a fixing surface, and drying and fixing means for locally heating the droplets and gasifying part of the droplets by irradiating the droplets ejected on the fixing surface with a laser beam. With such a configuration, the droplets can be dried rapidly, heating of the entire substrate is suppressed, and loss of alignment or breakage of wiring caused by the expansion of substrate can be avoided.

The apparatus for fixing a functional material in accordance with the present invention comprises droplet ejection means for discretely ejecting a plurality of droplets of a functional material dispersed in a solvent onto a fixing surface so that the droplets are not in contact with each other, and drying and fixing means for locally heating the droplets and gasifying part of the droplets by irradiating the droplets ejected on the fixing surface with a laser beam. With such a configuration, local movement of the droplets on the substrate can be suppressed and highly accurate droplet ejection control can be conducted with good stability.

In the preferred embodiment of the present invention, the droplet ejection means newly ejects second droplets so that they be brought into contact with the first droplets that were partially gasified with the drying and fixing means, and the drying and fixing means locally heats the second droplets and gasifies part of the second droplets by irradiating the second droplets with a laser beam. Ejecting second droplets so that they be brought into contact with the dried first droplets makes it possible to suppress local movement of the droplets on the substrate and to avoid the breakage of wiring or the like.

The apparatus for fixing a functional material in accordance with the present invention comprises first droplet ejection means for ejecting first droplets of a functional material dispersed in a solvent onto a fixing surface, first drying and fixing means for locally heating the droplets and gasifying part of the solvent contained in the first droplets by irradiating the first droplets ejected on the fixing surface with a laser beam, second droplet ejection means positioned downstream of the first droplet ejection means, for ejecting second droplets of a functional material dispersed in a solvent, and second drying and fixing means for locally heating the second droplets and gasifying part of the solvent contained in the second droplets by irradiating the second droplets ejected on the fixing surface with a laser beam. With such a configuration, the throughput can be increased.

In the preferred embodiment of the present invention, the aforesaid apparatus comprises sintering means for locally heating the functional material and sintering the functional material by irradiating the functional material dried and fixed on the fixing surface with a laser beam. Adjusting the intensity of the laser beam makes it possible to sinter the functional material.

The apparatus for fixing a functional material in accordance with the present invention comprises a sintering means for irradiating a functional material dried and fixed to a fixing surface with a laser beam, thereby locally heating the functional material and sintering the functional material. Adjusting the intensity of the laser beam makes it possible to sinter the functional material.

In the preferred embodiment of the present invention, the functional material contained in the solvent is dispersed in the solvent in a state in which the functional material is coated with a film. Coating the functional material with a film makes it possible to disperse the functional material in the solvent with good stability.

In the preferred embodiment of the present invention, the droplets comprise a photothermal conversion material having an absorption band in a wavelength region of the laser beam, and the drying and fixing means gasifies part of the solvent mainly by a photothermal conversion effect of the photothermal conversion material. Using the photothermal conversion material makes it possible to increase greatly the light utilization efficiency and heat the droplets effectively even at a laser wavelength of about 1 $\mu$m or less.

In the preferred embodiment of the present invention, the wavelength region of the laser beam is an IR region, and the drying and fixing means gasifies part of the solvent mainly by intrinsic absorption of the droplets. Using the intrinsic absorption of the droplets caused by local laser heating makes it possible to dry the droplets at a high rate.

In the preferred embodiment of the present invention, the drying and fixing means irradiates the droplets with a laser beam from the side where the droplets are ejected onto the fixing surface. In such a case, not only a substrate transparent with respect to the laser wavelength region, but also a substrate which is not transparent with respect to the laser wavelength region can be employed as the substrate for applying the droplets. Therefore, the range for material selection is expanded.

In the preferred embodiment of the present invention, the fixing surface is the surface of a substrate transparent with respect to a wavelength region of the laser beam, and the drying and fixing means irradiates the droplets with the laser beam from the rear surface side of the transparent substrate. Using a transparent substrate as the substrate for applying the droplets makes it possible to conduct laser irradiation from the rear side of the fixing surface and appropriate drying and fixing can be conducted even when the solvent contained in the droplets is a highly volatile solvent.

In the preferred embodiment of the present invention, the droplet ejection means ejects substantially simultaneously a plurality of droplets, and the drying and fixing means irradiates substantially simultaneously a plurality of droplets ejected onto the fixing surface with a plurality of laser beams. Because a plurality of droplet ejection and drying operations are carried out substantially simultaneously, the throughput can be increased. In the preferred embodiment of the present invention, the drying and fixing means comprises a diffraction optical element, splits a single laser beam into a plurality of laser beams with the diffraction optical element, and irradiates the plurality of droplets with the split beams. Using the diffraction optical element makes it possible to split a single laser beam into a plurality of diffraction beam arrays.

In the preferred embodiment of the present invention, the drying and fixing means comprises a semiconductor laser array in which a plurality of semiconductor lasers are arranged into an array and irradiates the plurality of droplets with a plurality of laser beams by using the semiconductor laser array. Using the semiconductor lasers makes it possible to reduce the size of the apparatus.

In the preferred embodiment of the present invention, the drying and fixing means adjusts a beam pitch of the laser beam so as to match the arrangement pitch of the droplets by rotating the diffraction optical element or the semiconductor laser array around the direction normal to the fixing surface. Such a configuration makes it possible to pattern the function material according to any pattern.

In the preferred embodiment of the present invention, the drying and fixing means irradiates together a plurality of droplets with a laser beam subjected to beam shaping such that the plurality of droplets can be laser irradiated at the same time. With such a configuration, the alignment of laser irradiation is facilitated and a plurality of droplets can be dried and fixed simultaneously. As a result, the throughput is increased.

In the preferred embodiment of the present invention, the intensity distribution of the laser beam has a ring-like, elliptic, or rod-like shape. If the intensity distribution of the laser beam has a ring-like shape, the outer edge of fine functional particles can be dried reliably. Therefore, diffusion of fine functional particles can be suppressed. Furthermore, if the intensity distribution of the laser beam has an elliptic or rod-like shape, the heating interval of the droplets can be necessarily and sufficiently extended. Therefore, stable drying and fixing can be conducted.

In the preferred embodiment of the present invention, the laser beam has a beam profile in which the intensity on the outer edge of the irradiated region is higher than that inside thereof. If the droplets are irradiated with the laser beam having such a beam profile, the outer edge of droplets can be dried reliably. therefore, displacement of the droplets from the impact position during drying can be suppressed.

In the preferred embodiment of the present invention, the drying and fixing means scans the droplets with a laser beam having an intensity gradient such that the intensity increases gradually from the front edge to the rear edge of the irradiated region, and gasifies part of the solvent contained in said droplets by laser irradiation in the vicinity of the front edge of the irradiated region, and the sintering means sinters the functional material by laser irradiation in the vicinity of the rear edge of the irradiated region. Conducting the drying step and sintering step continuously with the same laser beam increases the throughput.

In the preferred embodiment of the present invention, no specific limitation is placed on the functional material, but the functional material is preferably any of an electric wiring, a color filter, a photoresist, a microlens array, an electroluminescent material, or a biological substance.

The device fabrication method in accordance with the present invention is a method for fabricating a device by using the method for fixing a functional material in accordance with the present invention. The term "device" as used herein covers a wide range of objects such as functional elements or devices for the prescribed applications or for realizing the prescribed functions and also includes electric wirings which are the constituent elements thereof.

The electrooptical device in accordance with the present invention comprises the device fabricated by the device fabrication method in accordance with the present invention. The term " electrooptical device" as used herein is generally applied to display devices comprising electrooptical elements that emit light by electric action or change the state of the light that was supplied from the outside, including both the devices that emit the light by themselves and those that control the passage of light from the outside. Examples of such devices include active matrix display devices comprising liquid-crystal-elements, electrophoretic elements comprising a dispersion medium having electrophoretic particles dispersed therein, EL elements, or electron emission elements in which light is emitted when electrons generated by the application of electric field fall on a light-emitting plate, as the electrooptical elements.

The electronic apparatus in accordance with the present invention comprises the electrooptical device in accordance with the present invention. Here the term "electric apparatus" generally describes an apparatus comprising a circuit substrate and other elements and exhibiting a certain function. No specific limitation is placed on the configuration thereof. Examples of such electric apparatuses include, IC cards, cellular phones, video cameras, personal computers, head mount displays, rear- or front-type projectors, television (TV) sets, roll-up TV sets, fax units provided with a display function, finders of digital cameras, portable TV sets, DSP units, PDA, electronic notebooks, electrooptical bulletin boards, and displays for public announcements.

BRIEF DESCRIPTION OF THE DRAWINGS

FIG. 1 is a structural diagram of the apparatus for fixing a functional material of the first embodiment;

FIG. 2 is a structural diagram of the apparatus for fixing a functional material of the first embodiment;

FIG. 3 is a structural diagram of the apparatus for fixing a functional material of the first embodiment;

FIG. 4 is a structural diagram of the apparatus for fixing a functional material of the second embodiment;

FIG. 5 is an explanatory drawing illustrating the droplet ejection operation;

FIG. 6 is an explanatory drawing illustrating the droplet ejection operation;

FIG. 7 is a structural diagram of the apparatus for fixing a functional material of the third embodiment;

FIG. 8 is a cross-sectional view illustrating the droplet drying and sintering process;

FIG. 9 is a structural diagram of the apparatus for fixing a functional material of the fourth embodiment;

FIG. 10 is a structural diagram of the apparatus for fixing a functional material of the fourth embodiment;

FIG. 11 is a side view of the apparatus for fixing a functional material of the ninth embodiment;

FIG. 12 is a side view of the apparatus for fixing a functional material of the tenth embodiment;

FIG. 13 is an explanatory drawing illustrating the beam array of the fourth embodiment;

FIG. 14 is an explanatory drawing illustrating the beam array of the sixth embodiment;

FIG. 15 is an explanatory drawing illustrating the beam array of the seventh embodiment;

FIG. 16 is an explanatory drawing illustrating the beam array of the eighth embodiment;

FIG. 17 is an explanatory drawing illustrating the droplet ejection of the fourth embodiment;

FIG. 18 is an explanatory drawing illustrating the beam profile of the eleventh embodiment;

FIG. 19 is a graph illustrating temperature changes of the droplet of the eleventh embodiment;

FIG. 20 is an explanatory drawing illustrating the beam profile of the eleventh embodiment;

FIG. 21 is a graph illustrating the relation between the laser wavelength and the absorbance;

FIG. 22 is an explanatory drawing of an RFID tag;

FIG. 23 is an explanatory drawing of a color filter;

FIG. 24 is an explanatory drawing of a cellular phone;

FIG. 25 illustrates the conventional liquid droplet ejection; and

FIG. 26 illustrates the conventional liquid droplet ejection.

DESCRIPTION OF THE PREFERRED EMBODIMENTS

First Embodiment of the Present Invention

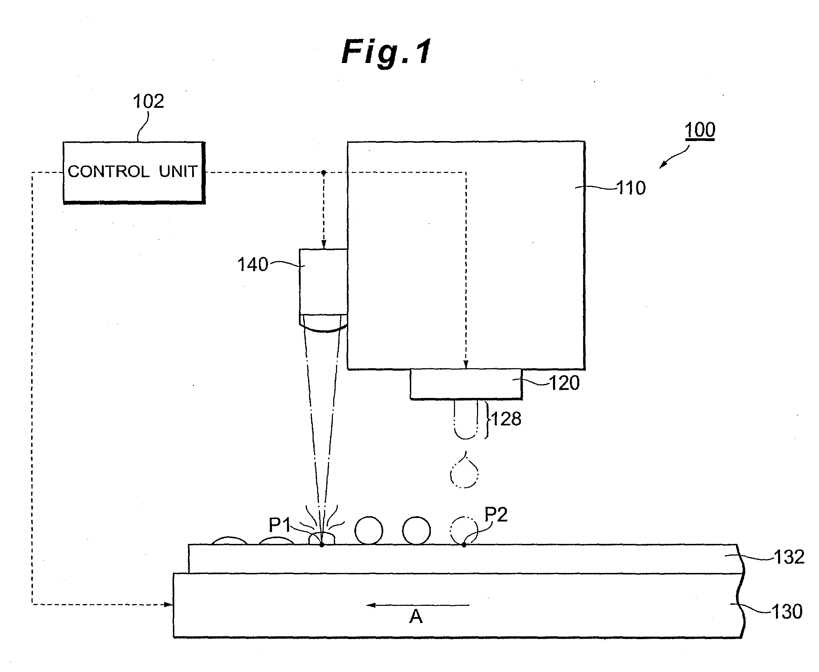

FIG. 1 is a structural diagram of the apparatus 100 for fixing a functional material of the first embodiment of the present invention.

Referring to the figure, a control unit 102 outputs drive signals to an ejection head 120, a substrate carriage 130, a laser 140, and an actuator 170 and controls the entire system. The control unit 102 is composed of a CPU, a timer clock, and a memory for storing the wiring pattern. A solution tank 110 stores a solution with a viscosity of about 20 mPa-sec that was prepared by mixing fine silver particles serving as a wiring material with an organic solution (solvent) such as $C_{14}H_{30}$ (n-tetradecane). The ejection head 120 receives the supply of the solution from the solution tank 110 under the control by the control unit 102, transforms the solution into droplets, and ejects the droplets.

The substrate carriage 130 transports the substrate 132 in the horizontal direction with respect to the ejection head 120 under the control by the control unit 102. In this process, the substrate carriage 130 scans the substrate 132 according to the wiring pattern stored in the memory contained in the control unit 102. As a result, a wiring pattern is drawn by the droplets ejected from the ejection head 120 onto the substrate 132. In the present embodiment, a linear wiring pattern extending parallel to the A direction shown in the figure is assumed to be stored in the memory of the control unit 102, and the scanning direction of the substrate 132 is assumed to the A direction.

A laser beam source 140 is provided at the side of the liquid tank 110. The laser beam source emits laser beams of two intensities (high level or low level) according to the drive signal outputted from the control unit 102 and focuses the laser beams on the horizontal plane comprising the upper surface of the substrate 132. More specifically, the laser beam is focused so that a straight line connecting the focusing position P1 and an impact position P2 of a droplet ejected from the ejection head 120 becomes parallel to the scanning direction (A direction in the present example) of the substrate 132. Therefore, the droplets applied to the substrate 132 pass through the focusing position P1 of the laser beam due to scanning in the A direction of the substrate 132. Of the laser beams emitted by the laser 140, the laser beam with a low-level intensity enhances the drying of the droplets applied to the substrate 132 and plays the role of fixing the droplets in the application position on the substrate 132. On the other hand, the laser beam with a high-level intensity plays the role of firing the groups of fine silver particles contained in the droplets.

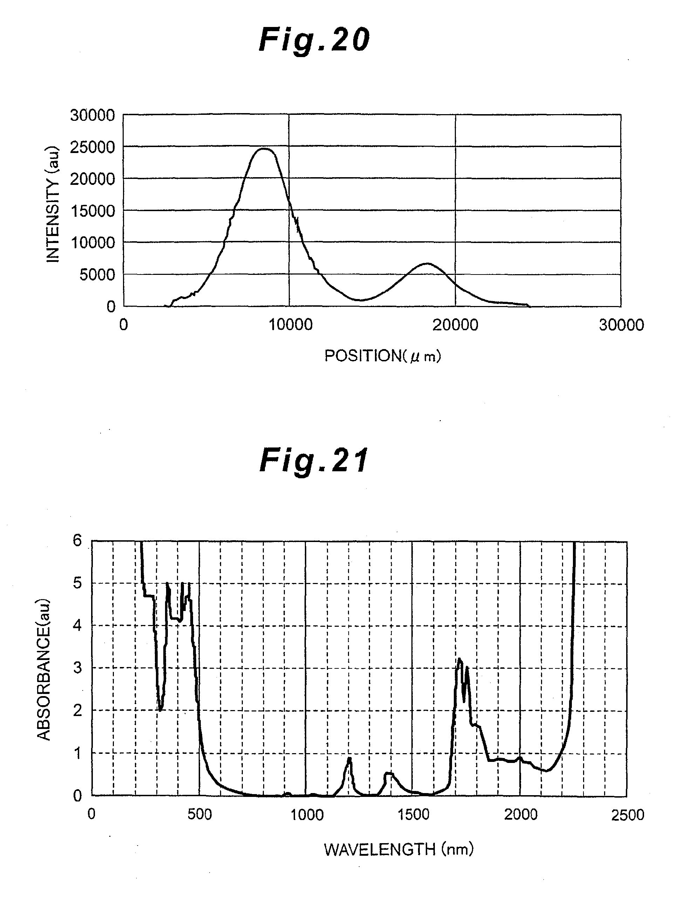

FIG. 21 shows the relation between the wavelength of the laser beam emitted from the laser beam source 140 and the absorbance of the substrate 132. The laser wavelength less than 500 nm or not less than 1600 nm is undesirable because of the increase in the absorbance of the substrate 132. Furthermore, when the laser wavelength is less than 500 nm, the absorbance of droplets increases in excess. A wavelength region of 500 nm to 1500 nm is preferred , and a range of 800 nm to 1100 nm is even more preferred as a wavelength region in which only the droplets can be appropriately heated.

The wiring patterning operation in the device for fixing a functional material 100 will be described below. In this explanation of the operation, an example will be considered in which a wiring extending parallel to the A direction is patterned by five cycles of scanning of the substrate 132. During the first scanning, the control unit 102 initiates the ejection of droplets from the ejection head 120 and provides for subsequent ejection of droplets at a fixed interval. Then, the control unit 102 scans the substrate 132 in the A direction with the substrate carriage 130 and provides for the application of the droplets ejected from the ejection head 120 with the substrate 132 such that a wiring pattern is drawn. At this time, the substrate carriage 130 scans the substrate 132 at a rate such that each of the droplets that have been continuously ejected collide with the substrate in positions that are separated from each other. As a result, the droplets are applied to the substrate 132 in a separated state.

Such an application of the droplets in a separated state is done for the following reason. Generally, if a plurality of droplets are applied so as to form a continuous pattern, the continuum of the droplets is deformed so as to assume the shape close to that of a sphere under the effect of surface tension, and local migration occurs. In the present embodiment, because the droplets are applied so that they are separated from each other, each droplets remains in the application position. Following the transportation of the substrate 132 by the substrate carriage 130, each of the droplets that are applied so that they be separated from each other is successively transported to the focusing portion P1 of the laser beam emitted from the laser 140. Once a droplet reaches the focusing position P1, the control unit 102 induces the emission of a laser beam with a low-level intensity from the laser 140 and focuses the laser beam on the upper surface of the substrate 132. The emission timing of the laser beam with a low-level intensity is determined by the distance between the ejection head 120 and the substrate 132, the ejection rate of droplets, the drive signal outputted to the ejection head 120, and the distance between the impact position P2 and focusing portion P1.

When the droplet located on the substrate 132 passes thought the focusing position P1, it is heated by the laser beam and the organic solution contained in the droplet is gasified. The substrate carriage 130 scans the substrate 132 at a speed such that the droplet passing through the focusing portion P1 is dried to a degree at which a certain amount of the organic solution remains therein. This scanning rate can be set according to the quantity of the organic solution contained in the droplet and intensity of the laser beam. Under the irradiation with the laser beam, the fine silver particles contained in the droplet are fixed on the substrate 132 in a scattered manner. If the droplets are not sufficiently dried in the first scanning cycle, re-scanning may be conducted only with respect to the treatment of irradiating the droplets with the laser beam.

In the present specification, a step in which the droplets are thus partially gasified to a degree at which a certain quantity of the solvent components contained in the droplets remains in the droplets and the droplets are thickened so that the functional material is not displaced form the impact position will be called "drying". The degree of displacement allowed in the drying step differs depending on the application of the functional material which is patterned. For example, when fine functional particles are patterned in a linear manner by tightly bonding the particles, as in the preparation of electric wiring, the displacement of the fine functional particles from the impact position is preferably adjusted to not more than half of the droplet diameter, preferably not more than 1/5 of the droplet diameter so as to prevent the breakdown of the electric wiring. Furthermore, when an electric wiring is formed, the intensity of the laser beam is preferably adjusted to a degree at which the fine functional particles are not completely sintered in the drying process. This is because if the individual fine functional particles are completely sintered in the drying process, the contact resistance between the fine functional particles becomes large.

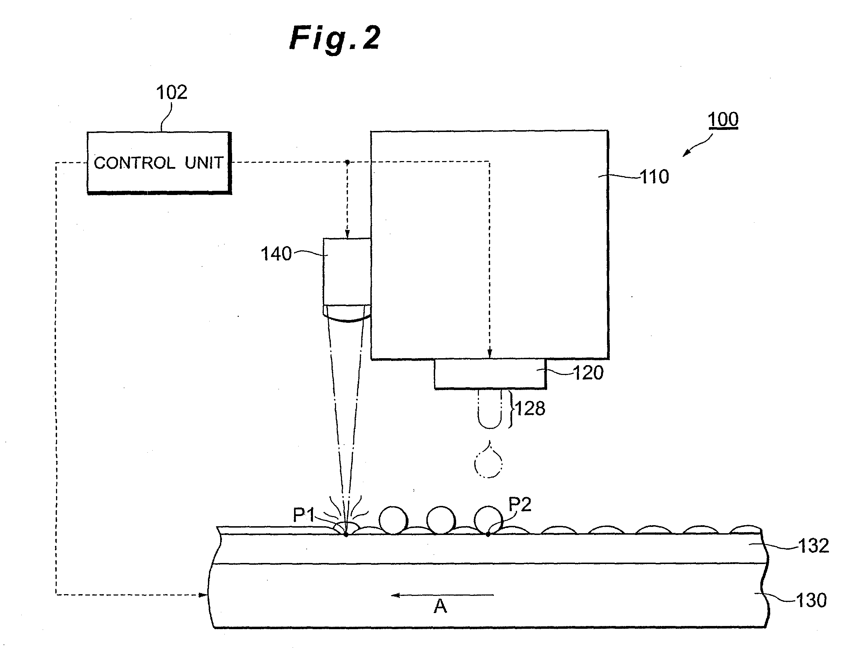

FIG. 2 shows the mode of second scanning. As shown in the figure, the substrate carriage 130 transports the substrate 132 so that the droplets ejected from the ejection head 120 fall so as to fill the gaps between the droplets that were applied by the first scanning. As a result of such impacts, the newly applied droplets are brought in partial contact with the droplets that were applied in the first scanning cycle, but the droplets applied in the first scanning cycle have been dried by the laser beam. Therefore, the newly applied droplets are not fused with the droplets applied in the first scanning cycle and local migration thereof is prevented. Each of the newly applied droplets is thereafter successively transported to the focusing position of the laser beam, heated and dried by the laser beam. Then, third and fourth scanning cycles are similarly implemented in the apparatus for fixing a functional material 100 and the fine silver particles contained in the droplets are stacked according to the wiring patter, while the droplets are being dried.

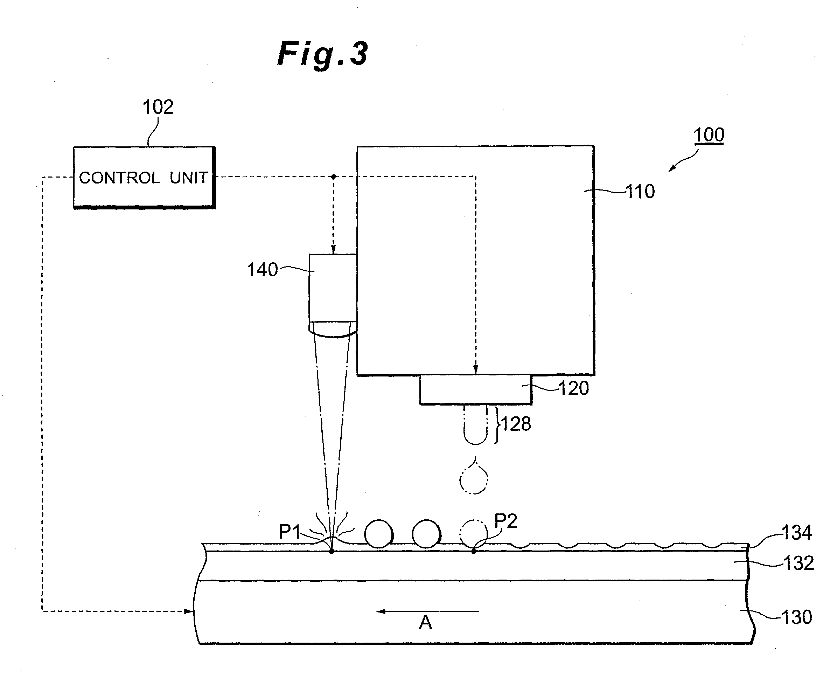

FIG. 3 illustrates the mode of the fifth scanning cycle. In the fifth scanning cycle, by contrast with the above-described scanning of the first to fourth cycles, a treatment relating to firing a group of fine silver particles is conducted instead of the treatment conducted to dry the droplets. The control unit 102 switches the laser intensity of the laser beam source 140 from a low level to a high level. Then, the control unit 102 initiates the ejection of droplets from the ejection head 120 and provides for subsequent ejection of droplets at a fixed interval. Further, the substrate carriage 130 transports the substrate 132 so that the droplets ejected from the ejection head 120 fall into the gaps between the droplets that were dried in the fourth scanning cycle. As a result, the ejected droplets are applied to the substrate 132 so as to be separated from each other.

The droplets that were thus applied are transported together with the droplets (group 134 of fine silver particles) that were dried in the previous scanning cycles toward the focusing position P1 of the laser beam. The laser beam source 140 irradiates the droplets that were newly applied and the group 134 of fine silver particles with a laser beam with a high-level intensity, the group 134 of fine silver particles is heated to a temperature of about 300°C, and the group 134 of fine silver particles 134 is fired. The fine silver particles present in the group 134 of fine silver particles are sufficiently sintered and the electric conductivity of the group 134 of fine silver particles becomes sufficient for a wiring.

As described hereinabove, with the apparatus 100 for fixing a functional material of the present embodiment, the droplets are dried by irradiating the droplets with a laser beam immediately after the application. As a result, the fine silver particles contained in the droplets can be dried and fixed to the substrate 132, without causing the displacement from the application position. Furthermore, with the method for fixing a functional material of the present embodiment, the applied droplets are forcibly dried with a laser beam. Therefore, the treatment time can be significantly shortened by comparison with the conventional patterning technology in which a process of applying the droplets and a process of naturally drying the applied droplets are repeatedly conducted in combination.

In the explanation of operation provided hereinabove, an example was considered in which the droplets were applied so that the droplets that have not been fixed were separated from each other, but the fine silver particles can be also fixed without displacement, by irradiation with a laser beam immediately after the application, when the droplets are applied so as to be partially connected.

Moreover, in the present embodiment, firing of the wiring was conducted by using a laser beam, this method having the following advantages. As described hereinabove, within the framework of the conventional technology, firing has been conducted by heating a group of fine silver particles 134 (wiring) together with the substrate 132. However, with such conventional method, the thermal expansion coefficient of the substrate 132 made from glass or the like is different from the thermal expansion coefficient of the wiring consisting of fine silver particles. For this reason, cracks occurred in the wiring during firing and the wiring could be broken. Another problem associated with the conventional method was that alignment could be lost due to the expansion of the entire substrate 132 and the ejection could not be conducted with good accuracy.

By contrast, in the present embodiment, only the portion of the substrate 132 where the substrate 132 where the group 134 of fine silver particles is present is locally heated by irradiation with a laser beam. Therefore, substantially no thermal expansion occurs in the substrate 132 and the probability of alignment loss or wiring breakdown is reduced. Moreover, with the present embodiment, only the group 134 of fine silver particles, rather than the entire substrate 132, is locally heated. Therefore, the consumption of energy can be greatly decreased by comparison with the method by which the particles are heated together with the substrate 132.

Second Embodiment of the Present Invention

In the first embodiment, an apparatus 100 for fixing a functional material was explained in which, after the droplets have been applied, the droplets were irradiated with a laser beam with a low-level intensity to fix the droplets. By contrast, in the second embodiment, an apparatus for fixing a functional material will be explained in which fixing of the droplets is conducted by irradiating the droplets with a laser beam substantially simultaneously with the application of the droplets. In the configuration of the apparatus for fixing a functional material of the present embodiment, the components identical to those of the first embodiment will be assigned with identical reference numerals.

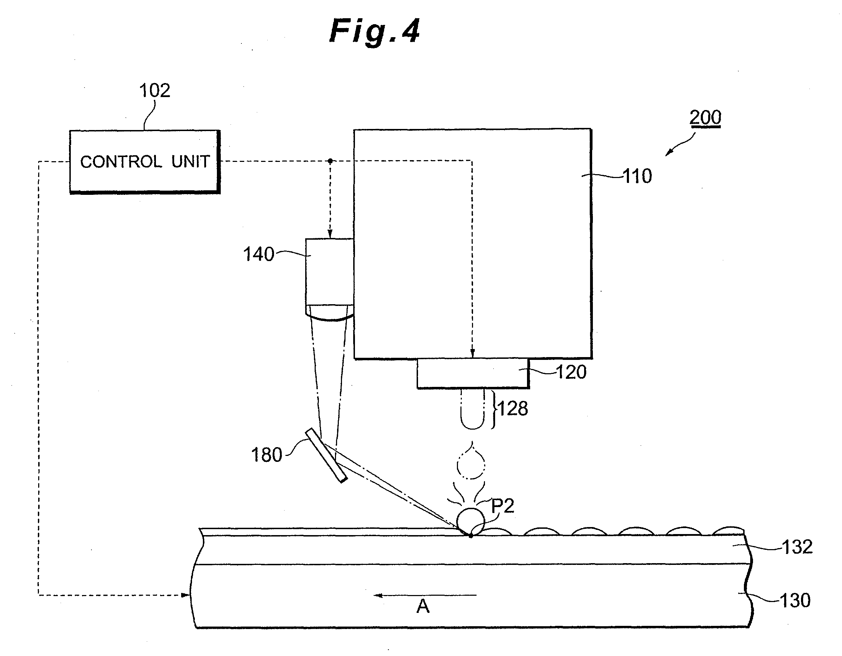

FIG. 4 is a structural diagram of the apparatus 200 for fixing a functional material relating to the second embodiment. As shown in the figure, in the device 200, a reflector 180 is additionally provided in the optical path of laser beam in the structure of the apparatus 100 for fixing a functional material of the first embodiment. The reflector 180 reflects the laser beam emitted from the laser beam source 140 so as to focus it on the impact position P2 of the droplets ejected from the ejection head 120 onto the upper surface of the substrate 132. If we suppose that the substrate 132 is practically not scanned within a period from the ejection of the droplet from the ejection head 120 to its impact with the substrate, then the reflector 180 will focus the laser beam on the point directly below a nozzle 126 provided at the ejection head 120, on the upper surface of the substrate 132.

With such a configuration, the laser beam is focused in the droplet impact position P2 by the reflector 180 during patterning. As a result, the droplets ejected from the ejection head are heated by the laser beam substantially simultaneously with the impact and dried substantially simultaneously with the impact. As a result, fine silver particles contained in the droplets can be fixed in the application position (impact position P2) similarly to the above-described first embodiment.

Furthermore, because in the apparatus 200 for fixing a functional material the droplets are dried substantially simultaneously with the impact, the following advantages are gained. Most of the ejection heads that are presently used have a configuration in which a plurality of nozzles 126 are arranged in a row with a constant pitch. With such a ejection head 120, one scanning makes it possible to execute the patterning by forming a plurality of wirings extending parallel to each other. With the apparatus 100 for fixing a functional material of the first embodiment, the absolute position in which a droplet is applied is different from the absolute position in which the droplet is dried. Therefore, the angle formed by the arrangement direction (C direction in the figure) of the nozzle 126 during scanning and the scanning direction A of the substrate is fixed. As a result, when the wiring pitch is changed, the pitch of the nozzles 126 themselves has to be changed. In other words, a separate ejection head 120 is required for each wiring pitch.

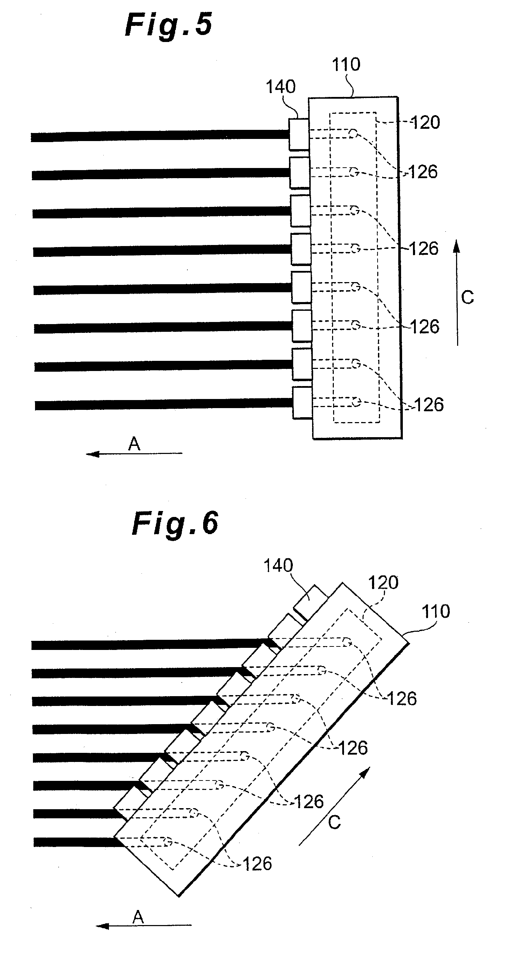

By contrast, with the apparatus 200 for fixing a functional material of the second embodiment, because the laser beam is focused in the impact position P2, the absolute position in which a droplet is applied is substantially the same as the absolute position in which the droplet is dried. Therefore, as shown in FIG. 6, patterning can be also conducted by tilting the scanning direction A of the substrate 132 with respect to the arrangement direction C of the nozzle 126. As a result, in the device for fixing a functional material 200, patterning of wirings with a plurality of pitches can be conducted by using a single ejection head 120.

Furthermore, in the present embodiment, an example was considered in which the reflected light (laser beam) was focused on the impact position P2 by using the reflector 180, but the present invention is not limited to such a configuration. For example, a configuration may be also used in which the laser 140 is provided in a position such that the light (laser beam) emitted from the laser beam source 140 is directly focused on the impact position P2. Third Embodiment of the Present Invention

In the above-described first embodiment, an apparatus 100 for fixing a functional material was explained in which a functional material is fixed by scanning the substrate 132 with respect to a set of the ejection head 120 and laser 140. By contrast, in the third embodiment, an apparatus for fixing a functional material will be explained in which the substrate 132 is scanned with respect to two sets of the ejection head and laser.

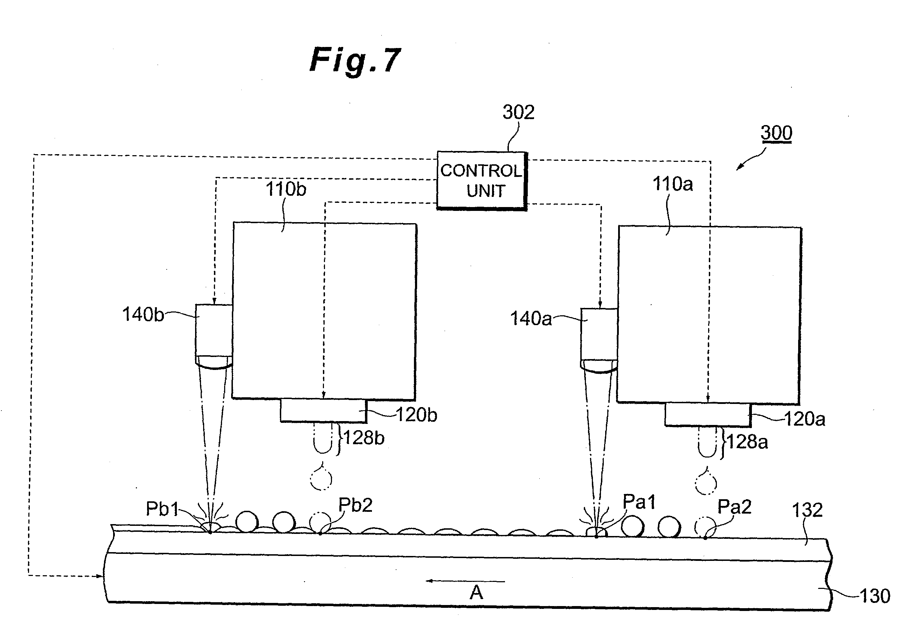

FIG. 7 is a structural diagram of the apparatus 300 for fixing a functional material relating to the third embodiment. As shown in the figure, the apparatus 300 comprises a solution tank 110a positioned upstream of the substrate 132 in the transportation direction A and a solution tank 110b positioned downstream. Among them, an ejection head 120a and a laser beam source 140a are installed on the solution tank 110a. On the other hand, an ejection head 120b and a laser beam source 140b are installed on the solution tank 110b. Furthermore, the focusing position Pa1 of the laser beam emitted from the laser beam source 140a, the impact position Pa2 of the droplets ejected from the ejection head 120a, the focusing position Pb1 of the laser beam emitted from the laser beam source 140b, and the impact position Pb2 of the droplets ejected from the ejection head 120b, are provided so as to be arranged on one straight line and this line be in the same direction and substantially parallel to the scanning direction A.

With such a configuration, the wiring patterning is conducted in the following manner in the apparatus 300 for fixing a functional material. The control unit 302 induces the ejection of droplets from the ejection head 120a disposed upstream and scans the substrate 132 so that the droplets are applied to the substrate 132 at a distance from each other. Then, the control unit 302 directs the laser beam from the laser beam source 140a toward the droplets applied by the ejection head 120a and dries the droplets. The control unit 302 induces the ejection of droplets from the ejection head 102b disposed downstream and scans the substrate 132 so that those droplets are applied between the droplets that were applied with the ejection head 120a located upstream. Then, the control unit 302 directs the laser beam from the laser beam source 140b toward the droplets that were applied with the ejection head 120b and dries the particles.

Thus, conducting the droplet application and drying treatments in parallel with two sets of components, a set of the ejection head 120a and laser beam source 140a and a set of the ejection head 120b and laser beam source 140b, makes it possible to reduce the number of scanning cycles and to increase productivity.

In the present embodiment, an example was described in which the apparatus 300 for fixing a functional material was provided with two sets of components, a set of the ejection head 120a and laser beam source 140a and a set of the ejection head 120b and laser beam source 140b. However, patterning can be conducted even more effectively by providing three sets of ejection heads and laser beam sources.

The present invention is not limited to the above-described specific configurations of preferred embodiments, and those embodiments can be modified or changed in various ways.

For example, in the above-described embodiments, a patterning example was considered in which the substrate 132 was scanned with respect to the ejection heads 120, 120a, 120b that assumed fixed positions, but such a configuration is not limiting. For example, patterning may be also conducted by scanning the ejection heads 120, 120a, 120b with respect to the substrate 132 that assumes a fixed position, or by scanning the substrate 132 and the ejection heads 120, 120a, 120b. Essentially, any scanning mode may be used, provided that a configuration is employed in which a functional material contained in the droplets is fixed on the substrate 132 by irradiating the droplets applied to the substrate 132 with a laser beam.

Fourth Embodiment of the Present Invention

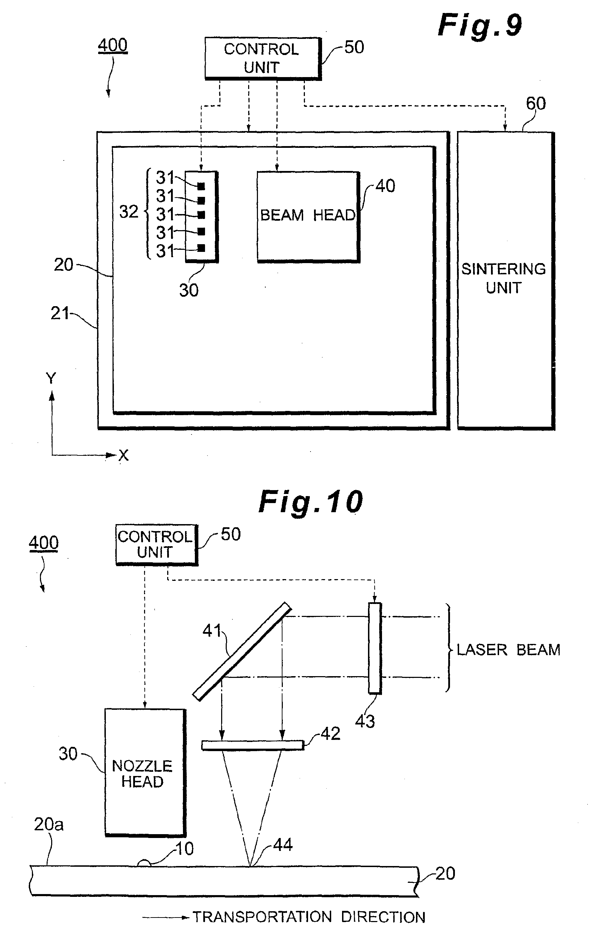

FIG. 9 is a plan view of an apparatus 400 for fixing a functional material. The apparatus 400 mainly comprises a substrate 20 for applying the droplets containing fine functional particles, a substrate stage 21 for moving the substrate 20 in the mutually orthogonal X axis direction and Y axis direction in a horizontal plane, a nozzle head (droplet ejection means) 30 for ejecting the droplets onto the substrate 20, a beam head (drying and fixing means) 40 for irradiating the droplets that were ejected onto the substrate 20 with a laser beam and drying and fixing the droplets by local heating, a sintering unit (sintering means) 60 for heating and sintering the fine functional particles that were dried and fixed on the substrate 20, and a control unit 50 for controlling various drive systems (transportation drive system of the substrate stage 21, droplet ejection drive system of the nozzle head 30, laser drive system of the beam head 40, and the heating control system of the sintering unit 60). In the nozzle head 30, a plurality of nozzles 31 are arranged into an array, thereby forming a nozzle array 32. An ink-jet head is preferably used as the nozzle head 30.

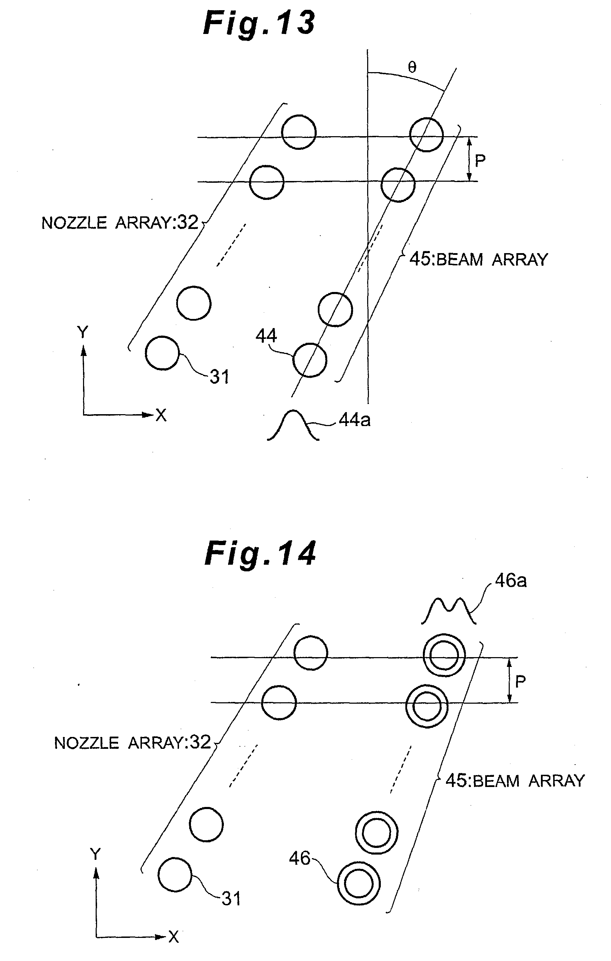

In the present embodiment, fine electrically conductive particles (for example, fine silver particles) are used as the fine functional particles, and an electric wiring is formed by ejecting and applying the droplets along a line, followed by drying and sintering. This configuration allows the nozzle head 30 to be rotated in the horizontal plane. Adjusting and holding an angle formed by the transportation direction of the substrate 20 and the arrangement direction of the nozzle array 32 to any angle makes it possible to vary freely the line pitch (wiring pitch P in FIGS. 13 to 16) of the droplets applied along the line. The substrate stage 21 transports the substrate 20 in the X direction and Y direction so that a prescribed wiring pattern is drawn on the substrate 20. The beam head 40 is means for generating a beam array on the substrate 20. For example, it is preferably a beam splitting element such as a diffraction optical element for generating a plurality of split beams from a single laser beam or a semiconductor laser array in which semiconductor lasers are arranged into an array. The beam array 40 can be similarly rotated in the horizontal plane and the beam pitch can be appropriately adjusted so as to match the line pitch of the droplets.

FIG. 10 is a side view of the apparatus 400 for fixing a functional material. Here, a diffraction optical element 42 for generating a diffraction beam array is employed as the aforesaid beam head 40. A laser beam emitted from a laser beam source (not shown in the figure) is guided from a reflection mirror 41 to the diffraction optical element 42 and converted into a plurality of split beams to form an array of beam spots 44 on the substrate 20 (in FIG. 10, the array is present in the direction normal to the paper surface). The nozzle head 30 is positioned upstream of the substrate 20 in the transportation direction, and the diffraction optical element 42 is positioned downstream. The droplets that adhered to the fixing surface 20a are transported downstream together with the substrate 20 and pass through the focusing positions of split beams. The droplets 10 that were locally irradiated with the laser beam are dried and fixed on the fixing surface 20a. Both the nozzle head 30 and the beam head 40 are disposed on the surface side of the substrate 20, and the direction in which the droplets are ejected on the fixing surface 20a coincides with the laser irradiation direction. A shutter 43 composed so that it can be switched by the control unit 50 is disposed in the optical path of the laser beam, and the switching timing of the shutter 43 is controlled so that laser irradiation is conducted when the droplet 10 reaches the focusing position of the beam spot 44 and then laser irradiation is terminated after the prescribed time elapses. The switching timing of the shutter 43 is determined by the ejection speed, traveling distance and ejection timing of droplets 10 and the distance from the impact position of droplet 10 to the focusing position of the beam spot 44.

FIG. 13 shows the relation between the wiring pitch and the diffraction beam array. The direction identical to the transportation direction of substrate 20 is taken as the X direction, and the direction perpendicular to the X direction is taken as the Y direction. Furthermore, the reference numeral 44 stands for the aforesaid beam spot, 44a - a beam profile (Gauss distribution), 45 - a diffraction beam array, P - wiring pitch, and $\theta$ - a rotation angle formed by the arrangement direction of the diffraction beam array 45 and the Y direction. If the wavelength of the laser beam is denoted by $\lambda$, the focusing distance - by f, the period of the diffraction optical element 42 - as d, then the beam pitch $\Delta$ ($\theta$) can be given by the following Formula (1). Here, M = 1 (odd branch), M = 2 (even branch). Adjusting the $\theta$ so that $\Delta$ ($\theta$) = P makes it possible to equalize the wiring pitch P and the beam pitch and to dry and fix a plurality of droplets 10 with a plurality of beam spots 44 at the same time within one transportation cycle. Furthermore, a beam pitch can be adjusted by controlling the tilt of the beam array 45 and adjusting the rotation angle theta. Therefore, it is possible to provide for the correspondence to a variety of wiring pitches P.

$$\Delta (0) = M\lambda f\cos\theta/d \qquad (1).$$

In the present embodiment, a YAG laser having a Gauss intensity distribution was employed and an element capable of both splitting and focusing was used as the diffraction optical element 42. The focusing distance f is 200 mm and the beam splitting number is 180. This element was fabricated as a transmission-type element on a $SiO_2$ substrate transparent with respect to a wavelength of 1.064 $\mu$m. When the wiring pitch P is 141.5 $\mu$m (180 dpi), if the focusing distance f is 200 mm and the incident beam diameter is 10 mm, then the focused beam diameter becomes 129 $\mu$m. This beam diameter is substantially equal to the diameter of the droplet 10 after the application.

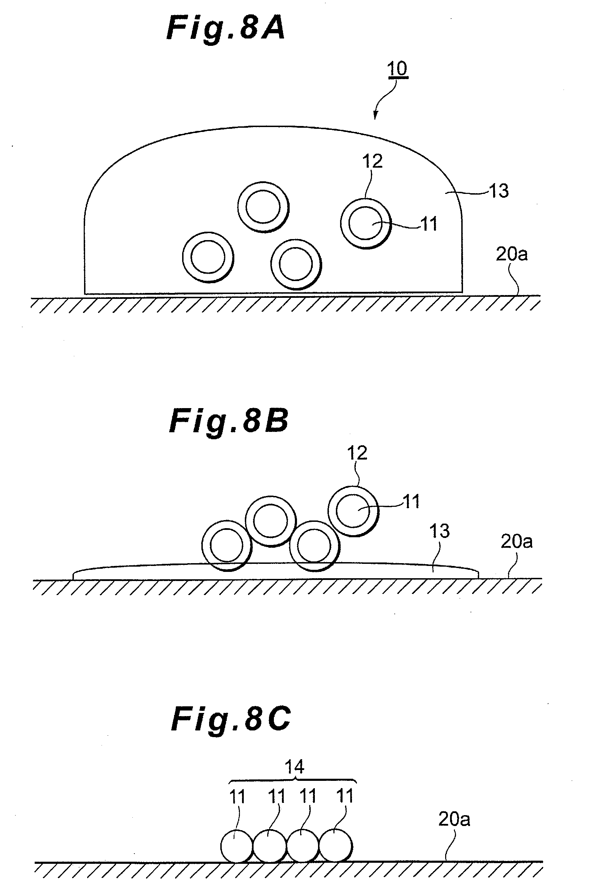

FIG. 8A illustrates the state of droplets ejected from the nozzle head 30 onto the fixing surface 20a. Droplets 10 are those of a solution in which fine functional particles 11 are contained in a solvent 13. Here, a wiring material such as fine silver particles was used as the fine functional particles 11, and an organic solvent such as $C_{14}H_{30}$ (n-tetradecane) was used as the solvent 13. In addition to the solvent 13, the droplets 10 may also contain a small amount of a surfactant or a protective agent for preventing the fine particles from coalescing. The viscosity of droplets 10 is preferably adjusted so as to obtain a stable droplet ejection characteristic. The surface of the fine functional particles 11 is covered with an extremely thin film 12 and is composed so as to prevent the fine functional particles 11 from coalescing in the solvent 13. The film preferably covers the entire surface of the fine functional particles 11, but coating may be provided to a degree preventing the fine functional particles 11 from adhering to each other, even if part of the surface is not covered. Here, the diameter of the fine functional particles 11 was about 3 nm, the thickness of the film 12 was about 1 nm, the viscosity of the droplets 10 was about 20 mPa-s, the volume thereof was about 10 pl and the droplet size was about 20 $\mu$m. Soda lime glass was used as the substrate 20 for the application of droplets 10.

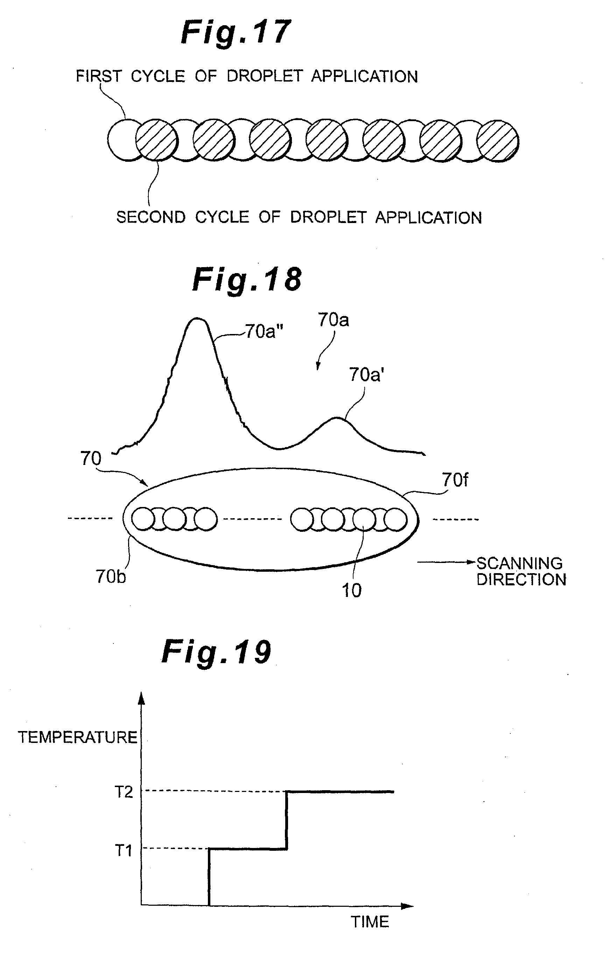

FIG. 17 shows the impact position of droplets 10 that collide with the fixing surface 20a. In the figure, empty circles denote the impact positions of the droplets 10 ejected in the first application cycle, and black circles denote the impact positions of the droplets 10 ejected in the second application cycle. In the application of the first cycle, droplet ejection is carried out as a dot line with an appropriate spacing between the droplets 10 so as to prevent local shift of the droplets under the effect of surface tension. If the droplets ejected in the first application cycle have been sufficiently dried and fixed by laser irradiation, the droplet ejection of the second cycle is carried out by controlling the transportation speed of the substrate 20 so as to fill the gaps between those dried and fixed droplets 10. If the droplets 10 are thus ejected, then the droplets 10 that were newly ejected in the second application cycle are brought in partial contact with the droplets 10 that have been ejected in the application of the first cycle, but because the droplets 10 that were applied in the first cycle have been dried and fixed by laser irradiation, the droplets 10 that were newly applied are not fused with the droplets 10 applied in the first cycle and local migration thereof is prevented.

Each of the newly applied droplets 10 is thereafter continuously transported to the focal position of the beam spot 44, heated by irradiation with the laser beam, dried and fixed. The third and fourth transportation cycles are thereafter similarly conducted and the fine functional particles 11 contained in the droplets 10 are stacked on the wiring pattern, while the droplets 10 are being dried.

The present invention is not limited to such an application conducted so that empty spaces are left between the droplets 10. For example, even when the droplets 10 overlap each other so as to be in partial contact, the coalescence of droplets 10 may be suppressed and the fine functional particles 11 may be dried and fixed in the prescribed positions by conducting irradiation with a laser beam immediately after the application of droplets 10.

FIG. 8 B illustrates the state of droplets 10 that were dried and fixed on the fixing surface 20a by irradiation with a laser beam (drying and fixing step). As for the laser beam irradiation conditions, the beam intensity and irradiation time of the laser beam (for example, the transportation speed of substrate 20) are adjusted so that part of droplets 10 containing the solvent 13 is gasified in a state in which the fine functional particles 11 are covered with the film 12. It is preferred that a laser beam source used for drying and fixing have a wavelength region causing heat generation by intrinsic absorption by the solvent 13, for example, a wavelength region in an near-IR region (about 0.8-1.0 $\mu$m). For example a Nd-YAG laser (1.064 $\mu$m) or a semiconductor laser (0.81, 0.94 $\mu$m) can be used as such a light source. With such a drying and fixing step, the droplets 10 are rapidly dried and fixed after the impact with the fixing surface 20a. Therefore, they neither fuse nor coalesce with other droplets 10.

Thus, it is preferred that under a condition that the fine functional particles are coated with the film 12, at least part of the droplets 10 comprising the solvent 13 is gasified by local heating with the laser, and the fine functional particles 11 are dried and fixed on the fixing surface 20a in a state in which they are coated with the film 12. Here, local laser heating includes not only the case in which one or a plurality of droplets 10 are heated by laser irradiation with a single beam spot, but also the case in which one or a plurality of droplets 10 are heated by laser irradiation with a wide beam. Because the conditions of laser irradiation vary according to the physical and chemical properties of the solvent 13 and fine functional particles 11, the laser beam source may be appropriately selected and laser irradiation conditions may be set according to those conditions.

FIG. 8 C illustrates a state in which the dried and fixed fine function particles 11 were sintered to form a wiring 14 (sintering step). The present step is conducted by batch heating (wide-region heating) the entire wiring pattern applied to the substrate 20 or part thereof in a high-temperature atmosphere with a sintering unit 60. If sintering of the fine function particles 11 is conducted, the film 12 is removed, the fine function particles 11 are bonded to each other, and a wiring (group of fine function particles) is formed. With this sintering step, the electric conductivity of the group of fine silver particles can be increased to a level necessary and sufficient for the electric wiring 14. In the present specification, the term "sintering step" describes a step of batch heating a group of fine function particles 11 that were dried and fixed.

As described hereinabove, with the present embodiment, the applied droplets 10 can be rapidly dried and fixed by local laser heating of the droplets 10. As a result, the fine function particles 11 contained in the droplets 10 can be fixed on the fixing surface 20a with good stability, without a displacement from the impact position caused by local movement of the droplets. Furthermore, because of intensive drying of the droplets 10 by local laser heating, the treatment time can be greatly reduced by comparison with the conventional wiring technology by which the droplet application step and natural drying step were conducted repeatedly.

Further, in the explanation above, an example of configuration was described in which the substrate 20 was transported in the horizontal direction upon fixing the position of the nozzle head 30 and beam head 40. This example is, however, not limiting. For example, patterning of the fine function particles 11 may be also conducted by scanning the nozzle head 30 and beam head 40 after fixing the position of the substrate 20. Of course, patterning of the fine function particles 11 may be also conducted by transporting or scanning the substrate 20, nozzle head 30, and beam head 40 with respect to each other.

Fifth Embodiment of the Present Invention

In the present embodiment, a pigment-type photothermal conversion material having an absorption band in the wavelength region of the laser beam is introduced in advance into the droplets 10, and the droplets are dried and fixed mainly by the photothermal conversion action of the photothermal conversion material. It is preferred that the photothermal conversion material be different from the material of fine functional particles 11 and have good solubility in the solvent 13. If the photothermal conversion material is used, the light utilization efficiency in the drying and fixing step can be greatly increased by comparison with the case in which the intrinsic absorption of the droplets was used. Furthermore, if the photothermal conversion material is used, the laser wavelength can be decreased to about 1 μm or less. As a result, a small and lightweight semiconductor laser can be used as a laser beam source. As a result, the size of the apparatus 500 for fixing a functional material can be decreased. Other merits of semiconductor lasers (LD) include high efficiency, long service life, and low voltage. Moreover, using a semiconductor laser makes it possible to generate a fine beam spot 44 and the heat locally the droplets 10 with a high accuracy. Furthermore, the photothermal conversion material can be formed on the substrate 20 and then fine functional particles 11 can be fixed on the photothermal conversion material. For example, a solvent containing a photothermal conversion material is ejected onto the substrate 20, for example, by a droplet ejection method, and the photothermal conversion material is formed on the substrate 20 by drying and sintering steps. Then, droplets 10 containing a functional material 11 such as fine electrically conductive particles is ejected and applied. The fine functional particles 11 can be then fixed on the substrate by the process described in fifth embodiment. In this case, too, the effect obtained is identical to that of the above-described fifth embodiment.

Sixth Embodiment of the Present Invention

In the present embodiment, as shown in FIG. 14, the beam intensity of the beam spot 46 has a ring-like shape. The reference symbol 46a stands for a beam profile. Adjusting the beam profile 46a so that the irradiation intensity on the outer edge of the irradiation spot is higher than the irradiation intensity inside the spot makes it possible to suppress the diffusion of fine functional particles 11 immediately after the impact of the droplets 10 with the fixing surface 20a and to prevent the increase in the wiring width. Furthermore, a fine and accurate wiring pattern can be drawn regardless of the concentration of the fine functional particles 11 and the droplet ejection quantity. The phase function of the above-mentioned diffraction optical element 42 may be devised appropriately to obtain such a beam profile 46a.

Seventh Embodiment of the Present Invention

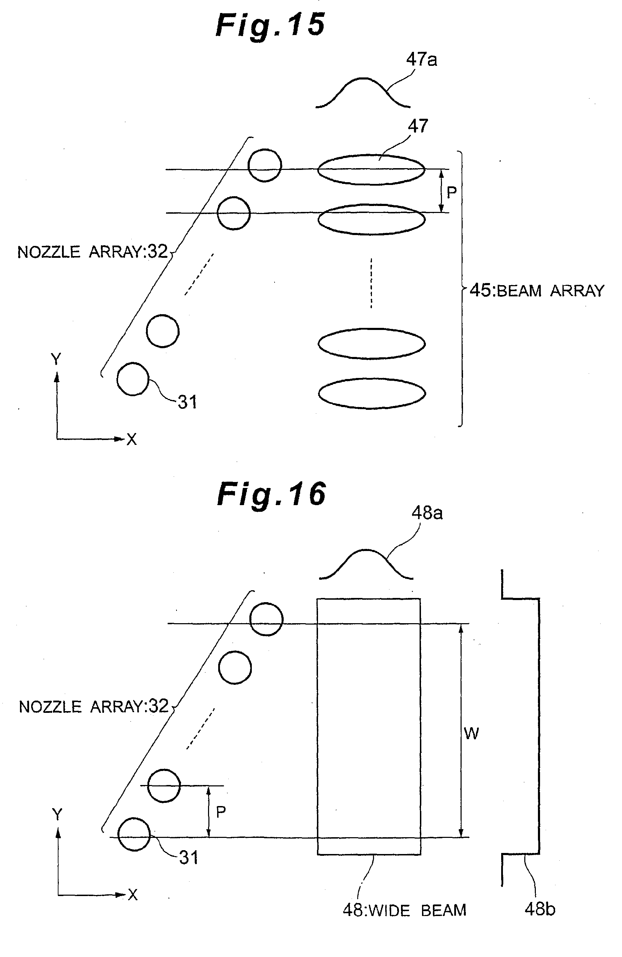

In the present embodiment, as shown in FIG. 15, the beam intensity of the beam spot 47 has an elliptic or rod-like shape with a long axis in the direction of substrate transportation (X direction). The reference symbol 47a stands for a beam profile (Gauss distribution). With such a configuration, the time of laser irradiation of the droplets 10 can be extended, without reducing the transportation speed of the substrate 20 and stable drying and fixing can be conducted. The phase function of the above-mentioned diffraction optical element 42 may be devised appropriately to obtain elliptical or rod-like shape of the beam intensity of the beam spot 47.

Eighth Embodiment of the Present Invention

In the present embodiment, as shown in FIG. 16, a wide beam 48 is used which is shaped into a rectangular form such that all of a plurality of droplets 10 can be laser irradiated simultaneously. The reference symbol 48a stands for a beam profile (Gauss distribution) in the X direction, and 48b - a beam profile in the Y direction. With such a configuration, alignment of laser irradiation can be conducted extremely easily. Furthermore, it is also possible to deal easily with changes in the arrangement pitch P of droplets 10. The phase function of the above-mentioned diffraction optical element 42 may be devised appropriately to generate the wide beam 48. However, this phase function does not include the beam splitting action.

Ninth Embodiment of the Present Invention

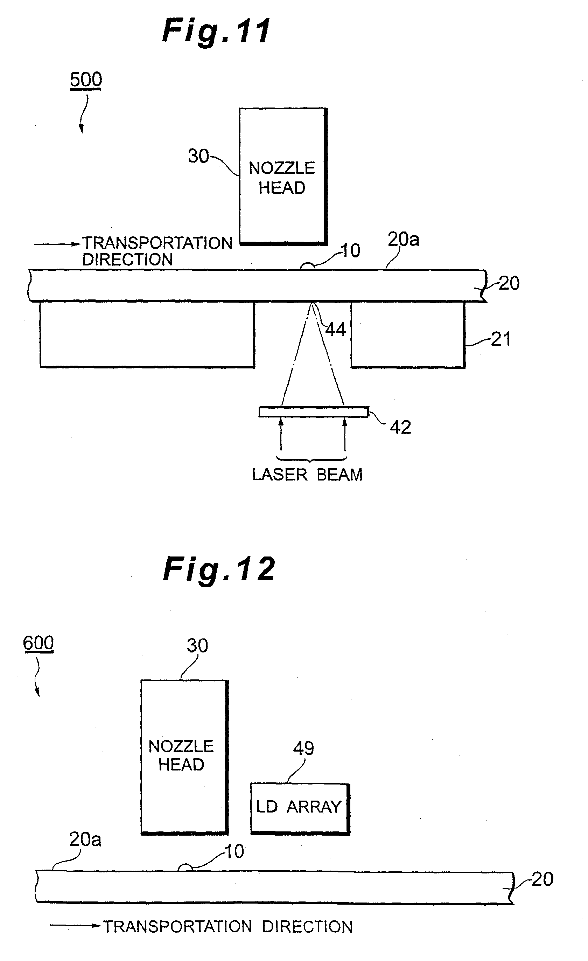

FIG. 11 is a structural diagram of an apparatus 500 for fixing a functional material of the present embodiment. In the apparatus 500, a nozzle head 30 is disposed on the front surface side (fixing surface side) of substrate 20, and a diffraction optical element 42 serving as a beam head is disposed on the rear surface side of the substrate 20. The substrate 20 is composed of a transparent material capable of transmitting a laser beam. With such a configuration, laser irradiation can be conducted simultaneously with the application of droplets 10 to the fixing surface 20a, and stable drying and fixing can be conducted even when a highly volatile solvent is used as the solvent 13.

Tenth Embodiment of the Present Invention

FIG. 12 is a structural diagram of an apparatus 600 for fixing a functional material of the present embodiment. In the apparatus 600, a semiconductor laser array 49 is provided as a beam head. Because the size of a single semiconductor laser is about 0.1 mm x 0.1 mm, the size of the entire device can be reduced. The semiconductor laser array 49 may be arranged not only on the front surface of substrate 20, but also on the rear surface thereof.

Eleventh Embodiment of the Present Invention

In the above-described embodiments, the drying step and sintering step were carried out separately. However, the two steps can be carried out continuously with the same laser beam by devising an appropriate beam profile of the laser beam. For example, as shown in FIG. 18, a laser beam having a beam profile 70a with a twin-peak intensity distribution is scanned over droplets 10 and drying is carried out with a portion 70a' of a low intensity whereas sintering is carried out with a portion 70a" of a high intensity. FIG. 20 shows the results obtained in measuring the beam intensity having a twin-peak intensity distribution. Changes in the temperature of laser-irradiated droplets 10 with time are shown in FIG. 19. Here, the temperature T1 is a temperature of droplets 10 that were heated mainly by laser irradiation from the vicinity of the front edge 70f of the irradiated region 70, and the beam profile 70a' was adjusted so that the temperature advantageous for drying and fixing was obtained. The temperature T2 is a temperature of droplets 10 that were heated mainly by laser irradiation from the vicinity of the rear edge 70b of the irradiated region 70, and the beam profile 70a" was adjusted so that the temperature advantageous for sintering was obtained. Thus adjusting the beam profile of the laser beam makes it possible to carry out the drying step and sintering process substantially simultaneously, with the same laser beam. Therefore, the throughput can be greatly increased. However, this procedure is preferably conducted after the droplet application of the second cycle has been completed, as shown in FIG. 17.

Twelfth Embodiment of the Present Invention

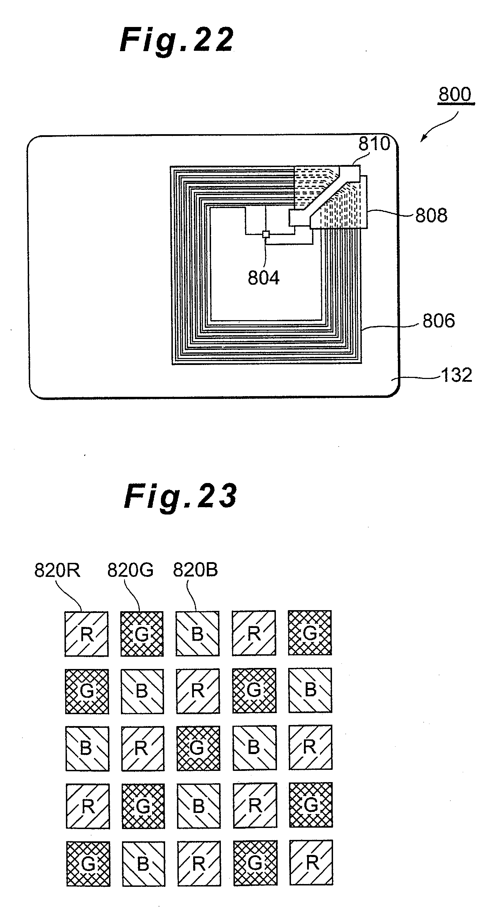

FIG. 22 shows an RFID tag having a wiring patterned with the above-described method for fixing a functional material. The RFID tag 800 shown herein is an electronic circuit used in the electromagnetic wave recognition systems and is carried on an IC card or the like. More specifically, the RFID tag 800 comprises an IC804 provided on a PET (polyethylene terephthalate) substrate 132, an antenna 806 formed to have a spiral shape and connected to the IC 804, a solder resist 808 provided partially on the antenna 806, and a loop-like connection wire 810 formed above the solder resistor 808 and connecting both ends of the antenna 806. Among those components, the antenna 806 was formed by the above-described method for fixing a functional material. Therefore, the antenna was fixed on the substrate 132, without causing the displacement of the droplets containing fine silver particles from the application position thereof.

FIG. 23 shows a color filter patterned by the above-described method for fixing a functional material. In this figure, each of the color filters 820R, 820G, and 820B was patterned by the method for fixing a functional material. More specifically, a solution containing a red pigment (color filter) was patterned on the coloration portion 820R, a solution containing a green pigment (color filter) was patterned on the coloration portion 820G, and a solution containing a blue pigment (color filter) was patterned on the coloration portion 820B. Here, each of the color filters 820R, 820G, and 820B was fixed in the application position of droplets (color filters), and the product quality was high because the probability of mixing between the color filters is low.

In addition, the method for fixing a functional material in accordance with the present invention is also applicable to cases of patterning the desired patterns of thermosetting resins or IR-curable resins employed for three-dimensional modeling, EL materials contained in electroluminescent (EL) elements, pigment-type inks for printing, microlens arrays used in liquid-crystal display panels and the like, and biological substances such as DNA or proteins. Furthermore, in the fifth embodiment, the front surface of the substrate 20 was described as the fixing surface 20a, but the present invention is not limited to this example, and the surface of fine functional particles 11 that have already been fixed can serve as the fixing surface 20a when the fine functional particles 11 demonstrate their functions or application by three-dimensional stacking, as in the case of thermosetting resins or IR-curable resins employed for three-dimensional modeling.

FIG. 24 shows an example of an electronic equipment carrying an electrooptical device comprising color filters formed by the above-described method for fixing a functional material. A cellular phone 900 shown in the figure carries as a display unit a liquid-crystal panel 940 having a color filter. The cellular phone 900 comprises a plurality of control buttons 910, and also a voice reception orifice 920, a voice transmitting orifice 930, and the liquid-crystal panel 940 as a display unit for displaying various types of information such as a telephone number. The aforesaid method is applicable to other electrooptical devices such as computers, projectors, digital cameras, movie cameras, PDA, vehicle devices, copiers, audio devices, and the like.

**Claims**

1. A method for fixing a functional material, comprising the steps of:

   ejecting a droplet of a functional material dispersed in a solvent onto a fixing surface;
   irradiating the droplet ejected onto said fixing surface with a laser beam; and
   locally heating said droplet and gasifying part of the droplet.

2. A method for fixing a functional material, comprising the steps of:

   discretely ejecting a plurality of droplets of a functional material dispersed in a solvent so that the plurality of droplets are not in contact with each other onto a fixing surface;
   irradiating the droplet ejected onto said fixing surface with a laser beam; and
   locally heating said droplet and gasifying part of the droplet.

3. The method for fixing a functional material, according to claim 2, further comprising the steps of:

   newly ejecting a second droplet onto said fixing surface so that the second droplet be brought into contact with the first droplet that was partially gasified;
   irradiating said second droplets with a laser beam; and
   locally heating said second droplet and gasifying part of the second droplets.

4. A method for fixing a functional material, using a first ink-jet head and a second ink-jet head positioned downstream of said first ink-jet head, said method comprising the steps of:

   discretely ejecting a plurality of droplets of a functional material dispersed in a solvent onto a fixing surface by using said first ink-jet head so that the first plurality of droplets are not in contact with each other;
   irradiating the first droplets ejected onto said fixing surface with a laser beam;
   locally heating at least two of said first droplets and gasifying part of the droplets;
   ejecting a second droplet by using said second ink-jet head so that the second droplet comes into contact with said two droplets that were partially dried;
   irradiating said second droplet with a laser beam; and
   locally heating said second droplet and gasifying part of the second droplet.

5. The method for fixing a functional material, according to claim 1, further comprising the steps of:

   irradiating said functional material dried and fixed to said fixing surface with a laser beam; and
   locally heating and sintering said functional material.

6. A method for fixing a functional material, comprising the steps of:

   irradiating a functional material dried and fixed to a fixing surface with a laser beam; and
   locally heating and sintering said functional material.

7. The method for fixing a functional material, according to claim 1, wherein said functional material contained in said droplet is dispersed in said solvent in a state in which said functional material is coated with a film.

8. The method for fixing a functional material, according to claim 1, wherein:

   said droplet contains a photothermal conversion material having an absorption band in a wavelength region of said laser beam; and
   part of said solvent principally is gasified by the photothermal conversion effect of said photothermal conversion material.

9. The method for fixing a functional material, according to claim 1, wherein:

   the wavelength region of said laser beam is in an IR region; and

part of said solvent principally is gasified by intrinsic absorption of said droplet.

10. The method for fixing a functional material, according to claim 1, wherein:

said droplet is irradiated with a laser beam from the side where said droplet is ejected onto said fixing surface.

11. The method for fixing a functional material, according to claim 1, wherein:

said fixing surface is a surface of a substrate transparent with respect to a wavelength region of the laser beam; and
said droplet is irradiated with the laser beam from the rear surface side of said transparent substrate.

12. The method for fixing a functional material, according to claim 1, further comprising the steps of:

ejecting a plurality of droplets substantially simultaneously; and
irradiating a plurality of droplets ejected onto said fixing surface with a plurality of laser beams substantially simultaneously.

13. The method for fixing a functional material, according to claim 12, further comprising the steps of:

splitting a single laser beam into a plurality of laser beams with a diffraction optical element; and
irradiating said plurality of droplets with the split beams.

14. The method for fixing a functional material, according to claim 12, further comprising a step of irradiating said plurality of droplets with a plurality of laser beams by using a semiconductor laser array in which a plurality of semiconductor lasers are arranged into an array.

15. The method for fixing a functional material, according to claim 13 or 14, further comprising the steps of:

rotating said diffraction optical element or said semiconductor laser array around the direction normal to said fixing surface; and
adjusting a beam pitch of said laser beam so as to match the arrangement pitch of said droplets.

16. The method for fixing a functional material, according to claim 1, further comprising a step of irradiating together a plurality of droplets with a laser beam shaped such that said plurality of droplets can be laser irradiated at the same time.

17. The method for fixing a functional material, according to claim 1, wherein:

the intensity distribution of said laser beam has a ring-like, elliptic, or rod-like shape.

18. The method for fixing a functional material, according to claim 17, wherein:

said laser beam has a beam profile in which the intensity on the outer edge of the irradiated region is higher than that inside thereof.

19. The method for fixing a functional material, according to claim 5, wherein:

drying and sintering of said droplets are implemented continuously by scanning said droplet with a laser beam having an intensity gradient such that the intensity increases gradually from the front edge to the rear edge of the irradiated region.

20. An apparatus for fixing a functional material, comprising:

droplet ejection means for ejecting a droplet of a functional material dispersed in a solvent onto a fixing surface; and
drying and fixing means for locally heating said droplet ejected onto said fixing surface and gasifying part of the solvent contained in said droplet by irradiating the droplet with a laser beam.

21. An apparatus for fixing a functional material, comprising:

droplet ejection means for discretely ejecting a plurality of droplets of a functional material dispersed in a solvent onto a fixing surface so that the plurality of droplets are not in contact with each other; and
drying and fixing means for locally heating said droplets ejected onto said fixing surface and gasifying part of the solvent contained in said droplets by irradiating the droplets with a laser beam.

22. The apparatus for fixing a functional material, according to claim 21, wherein:

said droplet ejection means newly ejects a second droplet so that the second droplet be brought into contact with the first droplet in which part of the solvent was partially gasified by said drying and fixing means; and

said drying and fixing means locally heats said second droplet and gasifies part of the solvent contained in said second droplet by irradiating said second droplet with a laser beam.

23. An apparatus for fixing a functional material, comprising:

first droplet ejection means for ejecting a first droplet of a functional material dispersed in a solvent onto a fixing surface;

first drying and fixing means for locally heating said first droplet ejected onto said fixing surface and gasifying part of the solvent contained in the first droplet by irradiating the first droplet with a laser beam;

second droplet ejection means positioned downstream of said first droplet ejection means, for ejecting a second droplet of a functional material dispersed in a solvent; and

second drying and fixing means for locally heating said second droplet ejected onto said fixing surface and gasifying part of the solvent contained in said second droplet by irradiating said second droplet with a laser beam.

24. The apparatus for fixing a functional material, according to claim 20, comprising:

sintering means for locally heating said functional material and sintering said functional material by irradiating said functional material dried and fixed to said fixing surface with a laser beam.

25. An apparatus for fixing a functional material, comprising a sintering means for irradiating a functional material dried and fixed to a fixing surface with a laser beam, thereby locally heating said functional material and sintering said functional material.

26. The apparatus for fixing a functional material, according to claim 20, wherein said functional material contained in said solvent is dispersed in said solvent in a state in which said functional material is coated with a film.

27. The apparatus for fixing a functional material, according to claim 20, wherein:

said droplets contains a photothermal conversion material having an absorption band in a wavelength region of said laser beam; and

said drying and fixing means gasifies part of said solvent principally by a photothermal conversion effect of said photothermal conversion material.

28. The apparatus for fixing a functional material, according to claim 20, wherein:

the wavelength region of said laser beam is an IR region; and

said drying and fixing means gasifies part of said solvent principally by intrinsic absorption of said droplets.

29. The apparatus for fixing a functional material, according to claim 20, wherein:

said drying and fixing means irradiates said droplet with a laser beam from the side where said droplet is ejected onto said fixing surface.

30. The apparatus for fixing a functional material, according to claim 20, wherein:

said fixing surface is a surface of a substrate transparent with respect to a wavelength region of the laser beam; and

said drying and fixing means irradiates said droplet with the laser beam from the rear surface side of said transparent substrate.

31. The apparatus for fixing a functional material, according to claim 20, wherein:

said droplet ejection means ejects substantially simultaneously a plurality of droplets; and

said drying and fixing means irradiates substantially simultaneously a plurality of droplets ejected onto said fixing surface with a plurality of laser beams.

32. The apparatus for fixing a functional material, according to claim 31, wherein:

said drying and fixing means comprises a diffraction optical element, splits a single laser beam into a plurality of laser beams by means of said diffraction optical element, and irradiates said plurality of droplets with the split beams.

33. The apparatus for fixing a functional material, according to claim 31, wherein:

said drying and fixing means comprises a semiconductor laser array in which a plurality of semiconductor lasers are arranged into an array and irradiates said plurality of droplets with a plurality of laser beams by using said semiconductor laser array.

**34.** The apparatus for fixing a functional material, according to claim 32 or 33, wherein:

said drying and fixing means adjusts a beam pitch of said laser beam so as to match the arrangement pitch of said droplets by rotating said diffraction optical element or said semiconductor laser array around the direction normal to said fixing surface.

**35.** The apparatus for fixing a functional material, according to claim 20, wherein:

said drying and fixing means irradiates together a plurality of droplets with a laser beam shaped such that said plurality of droplets can be laser irradiated at the same time.

**36.** The apparatus for fixing a functional material, according to claim 20, wherein:

the intensity distribution of said laser beam has a ring-like, elliptic, or rod-like shape.

**37.** The apparatus for fixing a functional material, according to claim 36, wherein:

said laser beam has a beam profile in which the intensity on the outer edge of the irradiated region is higher than that inside thereof.

**38.** The apparatus for fixing a functional material, according to claim 24, wherein:

said drying and fixing means scans said droplets with a laser beam having an intensity gradient such that the intensity increases gradually from the front edge to the rear edge of the irradiated region, and gasifies part of the solvent contained in said droplets by laser irradiation in the vicinity of the front edge of said irradiated region; and
said sintering means sinters said functional material by laser irradiation in the vicinity of the rear edge of said irradiated region.

**39.** The method for fixing a functional material, according to claim 1, wherein said functional material is any of an electric wiring, a color filter, a photoresist, a microlens array, an electroluminescent material, or a biological substance.

**40.** A device fabrication method for fabricating a device by using the method for fixing a functional material, according to claim 1.

**41.** An electrooptical device comprising a device fabricated by the device fabrication method according to claim 40.

**42.** An electronic equipment comprising the electrooptical device according to claim 41.

# Fig.1

EP 1 452 326 A2

## Fig.2

EP 1 452 326 A2

# Fig.3

# Fig.4

EP 1 452 326 A2

# Fig.5

# Fig.6

# Fig.7

EP 1 452 326 A2

## Fig.8A

## Fig.8B

## Fig.8C

*Fig.9*

400

CONTROL UNIT —50

60

31
31
31
31
31

32

30

BEAM HEAD —40

20

21

SINTERING UNIT

Y

X

*Fig.10*

400

CONTROL UNIT —50

41

43

LASER BEAM

42

30

NOZZLE HEAD

20a

10

44

20

TRANSPORTATION DIRECTION

# *Fig.11*

500

30

NOZZLE
HEAD

TRANSPORTATION
DIRECTION

10

20a

20

44

21

42

LASER BEAM

# *Fig.12*

600

30

NOZZLE
HEAD

49

LD ARRAY

20a

10

20

TRANSPORTATION DIRECTION

# Fig.13

θ

P

NOZZLE ARRAY:32

45:BEAM ARRAY

44

Y

31

X

44a

# Fig.14

46a

P

NOZZLE ARRAY:32

45:BEAM ARRAY

46

Y

31

X

# Fig.15

47a

47

NOZZLE ARRAY:32

P

45:BEAM ARRAY

Y

31

X

# Fig.16

48a

NOZZLE ARRAY:32

Y

P

31

X

W

48:WIDE BEAM

48b

## *Fig.17*

FIRST CYCLE OF DROPLET APPLICATION

SECOND CYCLE OF DROPLET APPLICATION

## *Fig.18*

70a"
70a
70a'
70
70f
70b
10
SCANNING DIRECTION

## *Fig.19*

TEMPERATURE
T2
T1
TIME

# Fig.20

# Fig.21

# Fig.22

# Fig.23

EP 1 452 326 A2

# Fig.24

# Fig.25  PRIOR ART

# Fig.26  PRIOR ART